# EUROPÄISCHE PATENTANMELDUNG

(11) **EP 4 640 690 A1**
(43) Veröffentlichungstag der Anmeldung: **29.10.2025**
(21) Anmeldenummer: 24172324.6
(22) Anmeldetag: 25.04.2024
(51) Int. Cl.: C07F 15/00, C23C 16/453, C23C 16/455

(54) **EINKERNIGE BISAMIDAT-DICARBONYL-KOMPLEXE DES RUTHENIUMS**

(71) Anmelder: Heraeus Precious Metals GmbH & Co. KG, 63450 Hanau (DE)
(72) Erfinder: Gock, Michael, 63450 Hanau (DE); Unkrig-Bau, Michael, 63450 Hanau (DE); Huster, Jan-Niklas, 44780 Bochum (DE); Obenlüneschloß, Jorit, 44780 Bochum (DE); Devi, Anjana, 44780 Bochum (DE)
(74) Vertreter: Heraeus IP

(57) **Zusammenfassung**

Einkernige Bisamidat-Dicarbonyl-Komplexe des Rutheniums ausgewählt aus der Gruppe bestehend aus Verbindungen der Formel Ru(CO)₂[OC(R1)NR2]₂,
wobei die Reste R1 ausgewählt sind unter -H, Methyl-, Ethyl-, Propyl-, Isopropyl-, Cyclopropyl- und isomeren Butylresten,
wobei die Reste R2 ausgewählt sind unter Methyl-, Ethyl-, Propyl-, Isopropyl-, Cyclopropyl- und isomeren Butylresten,
wobei die Reste R1 und R2 gleich oder verschieden sein können.

## Beschreibung

Die Erfindung betrifft einkernige Bisamidat-Dicarbonyl-Komplexe des Rutheniums, welche es als Rutheniumpräkursoren (Rutheniumvorläufer) erlauben, dünne Rutheniumschichten oder Rutheniumoxidschichten mittels CVD- oder ALD-Verfahren (CVD = chemical vapor deposition; ALD = atomic layer deposition) auf Substraten abzuscheiden. Diese neuen einkernigen Bisamidat-Dicarbonyl-Komplexe des Rutheniums können auch als Homogenkatalysatoren Verwendung finden.

Nach gängiger Definition und auch im Kontext der vorliegenden Patentanmeldung handelt es sich bei einem CVD-Verfahren um ein Verfahren, bei dem der Dampf eines Präkursors aus einem beheizten Reservoir unter Unterdruckbedingungen (0,1-10 mbar) kontinuierlich in einen Reaktorraum eingespeist wird und dort auf erwärmten Kontaktflächen eines Substrats, beispielsweise Kontaktflächen eines Halbleitersubstrats, durch thermische Zersetzung beispielsweise im Temperaturbereich von 200 bis 800°C, eine Schicht bildet. Dieser kontinuierliche Schichtwachstumsprozess kann durch die Beimischung eines Co-Reaktanden und/oder durch den Zufluss eines Inertträgergases wie beispielsweise Stickstoff oder Argon unterstützt werden.

Nach gängiger Definition und auch im Kontext der vorliegenden Patentanmeldung handelt es sich bei einem ALD-Verfahren um ein Verfahren, bei dem der Dampf eines Präkursors aus einem beheizten Reservoir unter Unterdruckbedingungen (0,01-10 mbar) sequenziell und im Wechsel mit einem Co-Reaktanden in einen Reaktorraum eingepulst wird. Dort kommt es dann auf den auf eine Temperatur beispielsweise im Bereich von >50 bis 300 °C erwärmten Kontaktflächen eines Substrats, beispielsweise Kontaktflächen eines Halbleitersubstrats, durch selbstlimitierende chemische Oberflächenreaktionen zur Bildung einer Schicht. Somit findet das Schichtwachstum während eines ALD-Prozesses nicht kontinuierlich, sondern in Zyklen statt. Der Prozess kann während jedes Pulses durch den Zufluss eines Inertträgergases wie beispielsweise Stickstoff oder Argon unterstützt werden.

Ruchi Gaur, Lallan Mishra, M. Aslam Siddiqi and Burak Atakan geben in RSC Adv., 2014, 4, 33785-33805 eine Übersicht über zur Gasphasenabscheidung von Rutheniumschichten verwendbare Ruthenium-Verbindungen.

Open Inorganic Chemistry Journal, 2008, Volume 2, Seiten 11-17 offenbart einkernige Bisamidinat-Dicarbonyl-Komplexe des Rutheniums, Ru(CO)₂[R2NC(R1)NR3]₂ mit der in zweidimensionaler Darstellung idealisierten Strukturformel 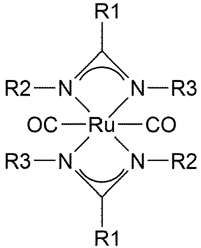 insbesondere mit R1 = Methyl und R2 = R3 = Isopropyl oder *tert*-Butyl. Die entsprechende Verbindung Bis[N,N'-bis-*tert*-butylacetamidinat]dicarbonylruthenium, Ru(CO)₂[*t*BuNC(CH₃)N*t*Bu]₂ mit der in zweidimensionaler Darstellung idealisierten Strukturformel 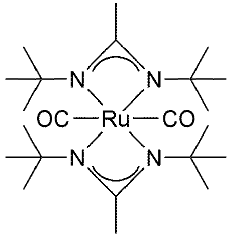 wird hierin auch als "Gordon's Precursor" bezeichnet und als Ru(CO)₂[N,N'-*t*Bu₂AAMD]₂ abgekürzt. Dabei steht "AAMD" für Acetamidinat. Journal of the Electrochemical Society 2007, Volume 154, Seiten D642-647 offenbart die Verwendung derartiger Bisamidinat-Dicarbonyl-Komplexe des Rutheniums für die Herstellung von Rutheniumschichten mittels CVD- oder ALD-Verfahren. Besagte Bisamidinat-Dicarbonyl-Komplexe des Rutheniums benötigen allerdings hohe Verdampfungstemperaturen bei der Verwendung in CVD- oder ALD-Verfahren.

Aufgabe der Erfindung war die Bereitstellung von Rutheniumverbindungen mit verbesserten Eigenschaften hinsichtlich einer Verwendung für die Herstellung von Rutheniumoxidschichten respektive Rutheniumschichten mittels CVD- oder ALD-Verfahren, insbesondere hinsichtlich einer Verwendung für die Herstellung von Rutheniumschichten mittels CVD- oder ALD-Verfahren im Halbleiterbereich. Die zu findenden Rutheniumverbindungen sollen eine hohe Flüchtigkeit bei gleichzeitiger thermischer Stabilität besitzen; mit anderen Worten, sie sollen unzersetzt bei möglichst geringer Temperatur bei Atmosphärendruck, insbesondere im Bereich von 100 bis 200°C verdampft werden können; die dazu zur Beurteilung heranzuziehende Onset-Verdampfungstemperatur kann thermogravimetrisch bestimmt werden, beispielsweise mit folgenden Messbedingungen: Heizrate von 5 K/min, Atmosphärendruck, Flussrate = 200 mL Stickstoff/min, horizontaler Fluss. Dazu kann die Thermograviemetriekurve nach der Tangentenmethode ausgewertet werden, wobei eine erste waagerechte Tangente an die Kurve im Bereich der maximalen Masse (Beginn der Messung) und eine zweite Tangente am Wendepunkt der Thermograviemetriekurve im Bereich der größten Massenabnahme konstruiert werden; die dabei am Schnittpunkt beider Tangenten abzulesende Temperatur entspricht der Onset-Verdampfungstemperatur. Die zu findenden Rutheniumverbindungen sollen sich ferner im Falle eines CVD-Verfahrens durch thermische Behandlung bei Temperaturen oberhalb der Siedetemperatur gegebenenfalls unter Verwendung eines Co-Reaktanden oder im Falle eines ALD-Verfahrens durch Umsetzung mit einem Co-Reaktanden bei dem üblicherweise herrschenden Prozessdruck zu metallischem Ruthenium zersetzen respektive zur Bildung einer Rutheniumoxidschicht führen. Bei der Zersetzung zu metallischem Ruthenium sollen sie sich zügig in Form möglichst reiner Schichten möglichst ohne oder mit nur geringen, tolerierbaren Verunreinigungen durch Fremdatome abscheiden lassen, beispielsweise mit einem jeweils <3 Atom-% betragenden Kohlenstoff-, Sauerstoff- respektive Stickstoffanteil. Das heißt für den Halbleiterbereich, dass sich aus den zu findenden Rutheniumverbindungen möglichst reine Rutheniummetallschichten per CVD- oder ALD-Verfahren auf Kontaktflächen von Halbleitern abscheiden lassen sollen. Die zu findenden Rutheniumverbindungen sollten hinreichend stabil gegenüber Luft und Wasser, nicht selbstentzündlich, und möglichst einfach zu synthetisieren und aufzureinigen sein.

Die Erfindung löst die Aufgabe durch Bereitstellung von einkernigen Bisamidat-Dicarbonyl-Komplexen des Rutheniums ausgewählt aus der Gruppe bestehend aus Verbindungen der Formel Ru(CO)₂[OC(R1)NR2]₂,
wobei die Reste R1 ausgewählt sind unter -H, Methyl-, Ethyl-, Propyl-, Isopropyl-, Cyclopropyl- und isomeren Butylresten,
wobei die Reste R2 ausgewählt sind unter Methyl-, Ethyl-, Propyl-, Isopropyl-, Cyclopropyl- und isomeren Butylresten,
wobei die Reste R1 und R2 gleich oder verschieden sein können.

Der hierin verwendete Begriff "isomere Butylreste" umfasst nichtcyclisches Butyl und Cyclobutyl.

Die erfindungsgemäßen durch die Formel Ru(CO)₂[OC(R1)NR2]₂ repräsentierten einkernigen Bisamidat-Dicarbonyl-Komplexe des Rutheniums haben folgende in zweidimensionaler Darstellung idealisierte Strukturformel:

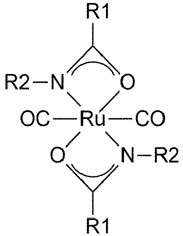

Das Ruthenium hat die Oxidationszahl +2 in den erfindungsgemäßen einkernigen Bisamidat-Dicarbonyl-Komplexen. Bei den anionischen Amidat-Liganden handelt es sich um zweizähnig koordinierende Liganden vom Typ (O-CR1-NR2)⁻.

Bevorzugte Beispiele für erfindungsgemäße einkernige Bisamidat-Dicarbonyl-Komplexe des Rutheniums umfassen Bis[N-isopropyl-tert-butylcarbonsäureamidat]dicarbonylruthenium der Formel Ru(CO)₂[(O-C(C(CH₃)₃)-N(CH(CH₃)₂)]₂, hierin auch abgekürzt als Ru(CO)₂[N-*i*Pr*t*BuAD]₂. Dabei steht "AD" für Amidat. Ein weiteres bevorzugtes Beispiel ist Bis[N-tert-butyl-isopropylcarbonsäureamidat]dicarbonylruthenium der Formel Ru(CO)₂[(O-C(CH(CH₃)₂)-N(C(CH₃)₃)]₂, hierin auch abgekürzt als Ru(CO)z[N-tBuiPrAD]z.

Die Erfindung betrifft auch ein Verfahren zur Herstellung erfindungsgemäßer einkerniger Bisamidat-Dicarbonyl-Komplexe des Rutheniums. In dem erfindungsgemäßen Verfahren wird zunächst ein Carbonsäureamid der Formel R1C(O)NHR2 mit Base deprotoniert unter Bildung eines entsprechenden Amidats (genauer eines Carbonsäureamidats) und anschließend, gegebenenfalls nach Isolation des Amidats, (a) mit einer Ruthenium(II)carbonylverbindung mit zwei oder mehr pro Rutheniumatom gebundenen CO-Liganden oder (b) mit einer Kombination aus RuCl₃ und Kohlenmonoxid umgesetzt; bei der Variante (b) hat das Kohlenmonoxid zwei Funktionen, es bewirkt eine Reduktion von Ru³⁺ zu Ru²⁺ und es fungiert als CO-Ligand, wobei angenommen werden kann, dass im Ergebnis intermediär Ruthenium(II)carbonyl-Spezies mit zwei oder mehr pro Rutheniumatom gebundenen CO-Liganden gebildet werden. Die Reaktion findet in flüssiger Phase, insbesondere in Lösung statt; sie kann in Wasser als nichtorganischem Lösungsmittel, in einem wässrigen organischen Lösungsmittel oder Lösungsmittelgemisch, oder bevorzugt in einem nichtwässrigen organischen Lösungsmittel oder einem nichtwässrigen Gemisch organischer Lösungsmittel durchgeführt werden. Bevorzugt handelt es sich bei den nichtwässrigen organischen Lösungsmitteln respektive den ein nichtwässriges Gemisch organischer Lösungsmittel ausmachenden organischen Lösungsmitteln um aprotische organische Lösungsmittel wie beispielsweise Dioxan, Tetrahydrofuran, Methyl-*tert*-butylether und Diethylether.

Für den Fachmann an sich unnötig zu erwähnen, dass es zweckmäßig ist unter weitestgehendem Ausschluss von Sauerstoff zu arbeiten.

Beispiele für Ruthenium(II)carbonylverbindung mit zwei oder mehr pro Rutheniumatom gebundenen CO-Liganden umfassen [Ru(CO)₃Cl₂]₂, Ru(CO)₂(PPh₃)₂Cl₂, sowie Vertreter der allgemeinen Formel Ru(CO)₂[amidinat]₂ wie beispielsweise Gordon's Precursor.

Beispiele für Basen umfassen Lithiumorganyle; Magnesiumorganyle, insbesondere Grignard-Verbindungen; Zinkorganyle; Alkalimetallhydride, Erdalkalimetallhydride, Alkalimetallamide, Alkalimetallhydroxide, Erdalkalimetallhydroxide, Alkalimetallhydrogencarbonate und Alkalimetallcarbonate.

Am Beispiel von ((CH₃)₂CH)C(O)NH(C(CH₃)₃), Butyllithium und [Ru(CO)₃Cl₂]₂ sei die Reaktionsfolge verdeutlicht:

4 ((CH₃)₂CH)C(O)NH(C(CH₃)₃) + 4 BuLi → 4 (O-C(CH(CH₃)₂)-N(C(CH₃)₃)Li + 4 C₄H₁₀↑

4 (O-C(CH(CH₃)₂)-N(C(CH₃)₃)Li + [Ru(CO)₃Cl₂]₂ → 2 Ru(CO)₂[O-C(CH(CH₃)₂)-N(C(CH₃)₃)]₂ + 2 CO↑ + 4 LiCl

Die erfindungsgemäßen einkernigen Bisamidat-Dicarbonyl-Komplexe des Rutheniums erfüllen die eingangs erläuterte Aufgabenstellung. Sie können als Homogenkatalysatoren Verwendung finden. Insbesondere sind sie hervorragend verwendbar als Präkursor für die Herstellung von Rutheniumschichten respektive Rutheniumoxidschichten auf Substraten mittels CVD- oder ALD-Verfahren, insbesondere von Rutheniumschichten im Halbleiterbereich, d.h. insbesondere für die Herstellung von Rutheniumschichten auf Kontaktflächen von Halbleitersubstraten. Sie sind bei Atmosphärendruck im Temperaturbereich von 100 bis 200°C verdampfbar, genauer gesagt, unzersetzt verdampfbar. Für die Abscheidung einer hochreinen Rutheniumschicht auf Kontaktflächen von Halbleitersubstraten mittels CVD- oder ALD-Verfahren eignen sich insbesondere folgende erfindungsgemäße einkernige Bisamidat-Dicarbonyl-Komplexe des Rutheniums: Bis[N-isopropyl-*tert*-butylcarbonsäureamidat]dicarbonylruthenium sowie Bis[N-*tert*-butyl-isopropylcarbonsäureamidat]dicarbonylruthenium.

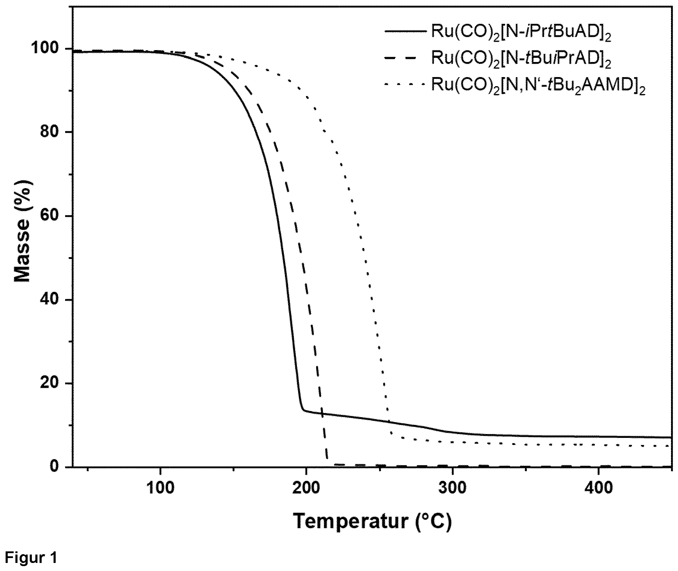

Die erfindungsgemäßen einkernigen Bisamidat-Dicarbonyl-Komplexe des Rutheniums sind den eingangs erwähnten Bisamidinat-Dicarbonyl-Komplexen des Rutheniums in Hinsicht auf die erläuterte Aufgabenstellung überlegen, wie ein Vergleich der erfindungsgemäßen Verbindungen Bis[N-isopropyl-*tert*-butylcarbonsäureamidat]dicarbonylruthenium und Bis[N-*tert*-butyl-isopropylcarbonsäureamidat]dicarbonylruthenium mit Gordon's Precursor zeigt. Aus der thermogravimetrischen Analyse dieser drei Verbindungen (vgl. Figur 1) ergibt sich, dass sich die beiden erfindungsgemäßen Verbindungen bei Atmosphärendruck im besonders bevorzugten Temperaturbereich von 100 bis 200°C verdampfen lassen, während Gordon's Precursor erst bei 215°C verdampft. Damit erfüllen die erfindungsgemäßen einkernigen Bisamidat-Dicarbonyl-Komplexe des Rutheniums die eingangs erläuterte Aufgabenstellung vollkommen und in gegenüber Gordon's Precursor überlegener Art und Weise.

### Beispiele

Alle Reaktionen und die Handhabung von luft- und feuchtigkeitsempfindlichen Verbindungen wurden unter einer trockenen Argon-Atmosphäre (Air Liquide, 99,995%) mittels konventioneller Schlenk-Technik durchgeführt. Alle organischen Lösungsmittel wurden getrocknet (MBraun Solvent Purification System) und über Molsieb (4 Ä) unter Argon-Atmosphäre gelagert. Alle Vakuumoperationen (z.B. Lösungsmittel entfernen, Sublimation, Vakuumdestillation) wurden bei einem Druck von 10⁻¹ bis 10⁻² mbar durchgeführt. Probenpräparationen zu analytischen Zwecken wurde in einer Glovebox unter Argon-Atmosphäre vorgenommen. Alle kommerziell verfügbaren Chemikalien wurden ohne weitere Aufreinigung eingesetzt.

Analysen der Elemente C, H und N wurde mit Hilfe eines CHNS-Analysators der Fa. Elementar, Model Vario Mikro Cube durchgeführt. Der Ru-Gehalt wurde nach einem Mikrowellenaufschluss an einer ICP-OES der Fa. Spectro, Modell Spectro Acros bestimmt. Der Sauerstoff-Gehalt wurde durch Summation der gewichtsprozentualen Messergebnisse von C, H, N und Ru und Differenzbildung zu 100 Gew.-% berechnet.

Zur NMR-spektroskopischen Charakterisierung wurden ein AVIII 400, ein AVIII 300 Nanobay, oder ein Bruker DPX200 NMR-Spektrometer verwendet. Alle Spektren wurden mit Hilfe des internen Lösungsmittelsignals (C₆D₅H) referenziert und mit der Software MestReNova v.10.0.2-15465 der Mestrelab Research S.L. analysiert.

LIFDI-MS (liquid-injection field desorption ionization mass spectrometry) wurde an einem JEOL AccuTof GCy (JMS-T100GCV) (JEOL, Tokyo, Japan), ausgerüstet mit einer LIFDI-Quelle von Linden CMS (Weyhe, Deutschland) gemessen. Der Emitterheizstrom wurde auf 20 mA/min bei konstanter Rate gesetzt.

Thermogravimetrische Analysen wurden auf einem in einer mit Stickstoff gefluteten Glovebox befindlichen Hitachi STA 200 bei Atmosphärendruck (Probengröße etwa 10 mg) mit einer Heizrate von 5 K/min (N₂, Flussrate = 200 mL/min, horizontaler Fluss) durchgeführt. Die so bestimmten Kurven wurden nach der eingangs beschriebenen Tangentenmethode ausgewertet.

### Vergleichsbeispiel 1 (Herstellung von Bis[N,N'-bis-tert-butylacetamidinat]dicarbonylruthenium, "Gordon's Precursor", Ru(CO)₂[N,N'-tBu₂AAMD]₂):

Die Synthese erfolgte wie in der Literatur (R. G. Gordon et al., Open Inorg. Chem. J. 2008, 2, 11-17) beschrieben. Die Verbindung wurde als blassgelber Feststoff erhalten.
¹H-NMR (200 MHz, C₆D₆) δ [ppm]H₃)-N), 1.35 (s, 18H, 2 -C(CH₃)₃), 1.23 (s, 18H, 2 -C(CH₃)₃). Die *tert*-Butyl-Gruppen sind nicht magnetisch äquivalent.
Onset-Verdampfungstemperatur: 215°C

### Beispiel 2 (Herstellung der den freien Amidat-Liganden zugrunde liegenden Carbonsäureamide):

Die Carbonsäureamide wurden analog zum Vorgehen wie in der Literatur (A. R. Prosser et al., Org. Lett. 2010, 12, 3968-3971.) beschrieben hergestellt.

### N-Isopropyl-tert-butylcarbonsäureamid:

Die Verbindung wurde als farbloser Feststoff erhalten.

¹H-NMR (300 MHz, C₆D₆) δ [ppm]HH₃)₂), 1.05 (s, 9H, -C(CH₃)₃), 0.87 (d, 6H, -CH(CH₃)₂).

### N-tert-Butylisopropylcarbonsäureamid:

Die Verbindung wurde als farbloser Feststoff erhalten.

¹H-NMR (400 MHz, C₆D₆) δ [ppm]HH₃)₂), 1.27 (s, 9H, -C(CH₃)₃), 1.07 (d, 6H, -CH(CH₃)₂).

### Erfindungsgemäßes Beispiel 3 (Herstellung von

### Bis{N-Isopropyl-tert-butylcarbonsäureamidat]dicarbonylruthenium):

N-Isopropyl-*tert*-butylcarbonsäureamid (1,12 g, 7,82 mmol, 4,0 Äquiv.) wurde in THF (25 mL) gelöst, die Lösung wurde im Eisbad auf 0°C gekühlt und n-Butyllithium (1,6 M in Hexan, 4,88 mL, 7,81 mmol, 4,0 Äquiv.) wurde langsam zugetropft. Nach Rühren bei Raumtemperatur für eine Stunde wurde die Reaktionslösung langsam zu einer 0°C kalten Suspension von [Ru(CO)₃Cl₂]₂ (1,00 g, 1,95 mmol, 1,0 Äquiv.) in THF (50 mL) gegeben. Das Reaktionsgemisch wurde für 48 h unter Rückfluss erhitzt, dabei klarte die ursprünglich orangefarbene Suspension auf und es wurde eine klare rote Lösung erhalten. Alle volatilen Komponenten wurden im Vakuum entfernt und es blieb ein wachsartiger, roter Feststoff zurück. Dieser wurde mit n-Hexan (2 x 30 mL) extrahiert. Nach dem Verdampfen des Lösungsmittels des Extrakts blieb ein blassgelber Feststoff zurück. Aufreinigung durch Sublimation (70°C bei 1×10⁻² mbar) ergab einen farblosen Feststoff.

### Elementaranalyse:

### C₁₈H₃₂N₂O₄Ru (441,53 g/mol)

| | C | H | N | O | Ru |
|---|---|---|---|---|---|
| Berechnet | 48,97% | 7,30% | 6,34% | 14,50% | 22,89% |
| Gefunden | 48,82% | 7,34% | 6,39% | 14,64% | 22,81% |

¹H-NMR (300 MHz, C₆D₆) δ [ppm]H₃)₂), 1.12 (s, 18H, -C(CH₃)₃), 1.02 (d, 6H, -CH(CH₃)₂), 0.88 (d, 6H, -CH(CH₃)₂). Die Methylgruppen der Isopropyleinheiten sind nicht magnetisch äquivalent.
¹³C-NMR (100 MHz, C₆D₆) δ [ppm]C₃)₃), 188.2 (2C, Ru-CO), 47.2 (2C, - CH(CH₃)₂), 40.1 (2C, -C(CH₃)₃), 27.7 (6C, -C(CH₃)₃), 24.6 (2C, -CH(CH₃)₂), 24.2 (2C, - CH(CH₃)₂). Die Methylgruppen der Isopropyleinheiten sind nicht magnetisch äquivalent.
LIFDI-MS (m/z): 442.04 = [M]⁺
Onset-Verdampfungstemperatur: 164°C

### Erfindungsgemäßes Beispiel 4 (Herstellung von

### Bis[N-tert-butyl-isopropylcarbonsäureamidatldicarbonylruthenium:

Die Synthese erfolgte analog zum erfindungsgemäßen Beispiel 3) unter Verwendung von N-tert-Butylisopropylcarbonsäureamid anstelle von N-Isopropyl-tert-butylcarbonsäureamid. Es wurde ein farbloser Feststoff erhalten.

### Elementaranalyse:

### C₁₈H₃₂N₂O₄Ru (441,53 g/mol)

| | C | H | N | O | Ru |
|---|---|---|---|---|---|
| Berechnet | 48,97% | 7,30% | 6,34% | 14,50% | 22,89% |
| Gefunden | 48,97% | 7,30% | 6,33% | 14,53% | 22,87% |

¹H-NMR (300 MHz, C₆D₆) δ [ppm]H₃)₂), 1.20 (d, 6H, -CH(CH₃)₂), 1.11 (d, 6H, -CH(CH₃)₂), 1.08 (s, 18H, -C(CH₃)₃). Die Methylgruppen der Isopropyleinheiten sind nicht magnetisch äquivalent.
¹³C-NMR (75 MHz, C₆D₆) δ [ppm]C₃)₂), 188.6 (2C, Ru-CO), 51.6 (2C, - C(CH₃)₃), 34.4 (2C, -CH(CH₃)₂), 32.2 (6C, -C(CH₃)₃), 20.0 (2C, -CH(CH₃)₂), 19.2 (2C, - CH(CH₃)₂). Die Methylgruppen der Isopropyleinheiten sind nicht magnetisch äquivalent.
LIFDI-MS (m/z): 442.10 = [M]⁺
Onset-Verdampfungstemperatur: 178°C

Figur 1 zeigt vergleichend die Ergebnisse der thermogravimetrischen Analysen von Ru(CO)₂[N-*i*PrtBuAD)]₂, Ru(CO)₂[N-*t*Bu*i*PrAD]₂, und Ru(CO)₂[N,N'-*t*Bu₂AAMD]₂.

## Patentansprüche

1. Einkernige Bisamidat-Dicarbonyl-Komplexe des Rutheniums ausgewählt aus der Gruppe bestehend aus Verbindungen der Formel Ru(CO)₂[OC(R1)NR2]₂,
wobei die Reste R1 ausgewählt sind unter -H, Methyl-, Ethyl-, Propyl-, Isopropyl-, Cyclopropyl- und isomeren Butylresten,
wobei die Reste R2 ausgewählt sind unter Methyl-, Ethyl-, Propyl-, Isopropyl-, Cyclopropyl- und isomeren Butylresten,
wobei die Reste R1 und R2 gleich oder verschieden sein können.

2. Einkernige Bisamidat-Dicarbonyl-Komplexe des Rutheniums nach Anspruch 1 ausgewählt aus der Gruppe bestehend aus Bis[N-isopropyl-tert-butylcarbonsäureamidat]dicarbonylruthenium der Formel Ru(CO)₂[(O-C(C(CH₃)₃)-N(CH(CH₃)₂)]₂ und aus Bis[N-*tert*-butyl-isopropylcarbonsäureamidat]dicarbonylruthenium der Formel Ru(CO)₂[(O-C(CH(CH₃)₂)-N(C(CH₃)₃)]₂.

3. Verfahren zur Herstellung einkerniger Bisamidat-Dicarbonyl-Komplexe des Rutheniums nach Anspruch 1, wobei zunächst ein Carbonsäureamid der Formel R1C(O)NHR2 mit Base unter Bildung eines entsprechenden Carbonsäureamidats deprotoniert und anschließend, gegebenenfalls nach Isolation des Amidats, (a) mit einer Ruthenium(II)carbonylverbindung mit zwei oder mehr pro Rutheniumatom gebundenen CO-Liganden oder (b) mit einer Kombination aus RuCl₃ und Kohlenmonoxid umgesetzt wird.

4. Verfahren nach Anspruch 3, wobei die Ruthenium(II)carbonylverbindung mit zwei oder mehr pro Rutheniumatom gebundenen CO-Liganden ausgewählt ist aus der Gruppe bestehend aus [Ru(CO)₃Cl₂]₂, Ru(CO)₂(PPh₃)₂Cl₂, sowie Vertretern der allgemeinen Formel Ru(CO)₂[amidinat]₂.

5. Verfahren nach Anspruch 3 oder 4, wobei die Base ausgewählt ist aus der Gruppe bestehend aus Lithiumorganylen; Magnesiumorganylen, Zinkorganylen, Alkalimetallhydriden Erdalkalimetallhydriden, Alkalimetallamiden, Alkalimetallhydroxiden, Erdalkalimetallhydroxiden, Alkalimetallhydrogencarbonaten und Alkalimetallcarbonaten.

6. Verwendung eines einkernigen Bisamidat-Dicarbonyl-Komplexes des Rutheniums nach Anspruch 1 oder 2 oder hergestellt nach einem Verfahren nach einem der Ansprüche 3 bis 5 als Homogenkatalysator oder als Präkursor für die Herstellung von Rutheniumschichten respektive Rutheniumoxidschichten auf Substraten mittels CVD- oder ALD-Verfahren.

7. Verwendung eines einkernigen Bisamidat-Dicarbonyl-Komplexes des Rutheniums nach Anspruch 1 oder 2 oder hergestellt nach einem Verfahren nach einem der Ansprüche 3 bis 5 als Präkursor für die Herstellung von Rutheniumschichten auf Kontaktflächen von Halbleitersubstraten mittels CVD- oder ALD-Verfahren.
